# EUROPÄISCHE PATENTSCHRIFT

(11) **EP 0 813 753 B1**
(45) Veröffentlichungstag und Bekanntmachung des Hinweises auf die Patenterteilung: **21.02.2007**
(21) Anmeldenummer: 96904750.5
(22) Anmeldetag: 07.03.1996
(51) Int. Cl.: H01L 31/18, H01L 31/068, H01L 31/0288

(54) **SOLARZELLE MIT BACK-SURFACE-FIELD UND VERFAHREN ZUR HERSTELLUNG**
SOLAR CELL WITH BACK SURFACE FIELD AND PROCESS FOR PRODUCING IT
CELLULE SOLAIRE AVEC CHAMP ELECTRIQUE ARRIERE ET PROCEDE DE FABRICATION DE LADITE CELLULE

(30) Priorität: 10.03.1995 DE 19508712
(43) Veröffentlichungstag der Anmeldung: 29.12.1997
(73) Patentinhaber: Shell Solar GmbH, 81739 München (DE)
(72) Erfinder: SCHLOSSER, Reinhold, D-80993 München (DE); MÜNZER, Adolf, D-85716 Unterschlei heim (DE)
(74) Vertreter: Rau, Albrecht
(86) Internationale Anmeldenummer: PCT/DE1996/000415
(87) Internationale Veröffentlichungsnummer: WO 1996/028851

(56) Entgegenhaltungen:
- WO-A-91/19323
- 14TH IEEE PHOTOVOLTAIC SPECIALISTS CONFERENCE, 7. - 10.Januar 1980, SAN DIEGO, USA, Seiten 811-814, XP002006564 R.E. THOMAS ET AL.: "Solid source diffusion process for silicon solar cells"
- 17TH IEEE PHOTOVOLTAIC SPECIALISTS CONFERENCE, 1. - 4.Mai 1984, KISSIMMEE, USA, Seiten 138-143, XP000013418 M. GILLANDERS ET AL.: "LOW ALPHA, BORON BSF SOLAR CELL"
- 11TH EC PHOTOVOLTAIC SOLAR ENERGY CONFERENCE, 12. - 16.Oktober 1992, MONTREUX, CH, Seiten 164-167, XP002006565 J. NIJS ET AL.: "Towards 16% efficient polycrystalline silicon solar cells, using a relatively simple technology"
- SOLAR CELLS, Bd. 17, Nr. 1, März 1986, LAUSANNE CH, Seiten 119-133, XP002006566 A. ROHATGI ET AL.: "High-efficiency silicon solar cells: development, current issues and future directions"
- JOURNAL OF THE ELECTROCHEMICAL SOCIETY, Bd. 134, Nr. 12, Dezember 1987, MANCHESTER, NEW HAMPSHIRE US, Seiten 3160-3164, XP002006567 R.B. CAMPBELL ET AL.: "The fabrication and analysis of bifacial solar cells from dendritic web silicon substrates"

## Beschreibung

Beim Versuch, die Dicke von Siliziumsolarzellen zu reduzieren, wird ein abnehmender Wirkungsgrad der Solarzelle beobachtet. Dies ist zum einen auf die bei dünnerer Absorptionslänge nicht mehr vollständige Absorption des Sonnenlichts zurückzuführen. Zum anderen werden vermehrt Ladungsträger in der Nähe der Rückseite erzeugt, wobei Minoritätsladungsträger durch Diffusion die Rückelektrode erreichen können und dadurch den durch die Majoritätsladungsträger erzeugten Strom reduzieren.

Durch eine hochdotierte Schicht auf der Rückseite ist es möglich, ein der Diffusion der Minoritätsladungsträger entgegenwirkendes Feld, ein sogenannten Back-Surface-Field zu erzeugen. Bei einem Solarzellenaufbau mit einem p-dotierten Solarzellenkörper und einem n⁺-dotierten Emitter an der Lichteinfalls- bzw. Vorderseite der Solarzelle ist dazu eine p⁺-Dotierung an der Rückseite erforderlich. Zu deren Erzeugung wird vielfach Aluminium vorgeschlagen, welches sich als dünne Schicht zum Beispiel durch Aufdampfen auf der Rückseite aufbringen und durch einen Temperschritt eintreiben bzw. einlegieren läßt. Möglich ist es auch, die p⁺-Dotierung durch das Aufbringen aluminiumhaltiger Rückkontakte und entsprechendes Eintreiben des Aluminiums zu erzeugen. Möglich ist es auch, Aluminium aus einer Feststoff-Diffusionsquelle in das Solarzellensubstrat einzudiffundieren. Dies ist allerdings mit dem Nachteil verbunden, daß das Solarzellensubstrat auf beiden Seiten aluminiumdotiert wird, wobei eine p⁺pp⁺-Struktur erzeugt wird.

Auch Bor ist zur Erzeugung einer p-Dotierung geeignet. Ein entsprechendes Back-Surface-Field kann dabei durch Gasdiffusion einer entsprechend flüchtigen bzw. gasförmigen Borverbindung, durch Aufbringen einer borhaltigen Siliziumschicht auf der Rückseite oder durch Aufbringen einer flüssigen dotierstoffhaltigen Lösung erzeugt werden. Bei den für das Eintreiben der Dotierung erforderlichen Temperaturen wird jedoch aufgrund der hohen Flüchtigkeit der Borverbindungen stets eine Rundum-Diffusion beobachtet, die durch eine Maskierung der nicht zu dotierenden Solarzellenbereiche verhindert werden muß.

Die verfahrensmäßig einfach herzustellende p+-Dotierung mit Aluminium hat den Nachteil einer erhöhten Korrosionsanfälligkeit. Im Laufe der Zeit können sich aluminiumhaltige Schichtbereiche zersetzen und ablösen, was zur Beschädigung der Rückseitenkontakte und zur Reduzierung der Solarzellenleistung führen kann.

Aus 11th E.C. PHOTOVOLTAIC SOLAR ENERGY CONFERENCE, 12.-16.10.1992, Montreux, Schweiz, Seiten 164 - 167 ist ein Verfahren zur Herstellung einer Silizium-Solarzelle bekannt, bei welchem eine Bor-dotierte Oxidschicht auf der Rückseite eines Silizium-Wafers aufgebracht und anschließend das Bor bei einer Temperatur von 940°C in das Silizium eindiffundiert wird. Danach wird eine Emitterschicht durch Phosphordiffusion erzeugt, und schließlich durch Ätzen Kontakte aufgebracht.

Aus WO-A-9119323 ist ein Verfahren zur Herstellung einer Siliziumsolarzelle bekannt, welches insbesondere auf die Herstellung von dotierten Bereichen gerichtet ist. Hierbei wird eine oxidbildende Maskenschicht, welche einen Dotierstoff enthält, auf einen Teil der Oberfläche eines Halbleitersubstrats aufgebracht, und anschließend das Substrat auf eine Temperatur erhitzt, welche ausreichend ist für die Diffusion eines Teils des Dotierstoffes aus der Maskenschicht in das Halbleitersubstrat, wobei auch eine Autodotierung der nackten Oberfläche des Halbleitersubstrats stattfindet. Die autodotierten Bereiche des Halbleitersubstrats werden weggeätzt, während die Maskenschicht eine Schutzschicht für die dotierten Bereiche unter der Maskenschicht darstellt.

Problem der vorliegenden Erfindung ist es nun, ein Verfahren zum Herstellen eines Back-Surface-Fields bei einer Silizium-Solarzelle anzugeben, welches ohne großen Aufwand in ein herkömmliches Herstellverfahren für Solarzellen integriert werden kann, welches einfach und sicher durchzuführen ist und welches zu einer langzeitstabilen Solarzelle mit reduzierter Korrosionsanfälligkeit führt. Mit dem Verfahren soll es möglich sein, mit Hilfe dünnerer Solarzellen Siliziummaterial einzusparen und dennoch einen höheren Solarzellenwirkungsgrad zu erreichen.

Dieses Problem wird erfindungsgemäß durch ein Verfahren nach dem Anspruch 1 gelöst. Eine so hergestellte Solarzelle ist dem Anspruch 9 zu entnehmen, während weitere Ausgestaltungen der Erfindung den Unteransprüchen zu entnehmen sind. Grundlegende Idee der Erfindung ist es, die p+-Dotierung des Back-Surface-Fields durch Austreiben von Bor aus einer borhaltigen Diffusionsquellenschicht zu erzeugen. Die nicht gewünschte Dotierung von Rändern und Vorderseite des Wafers wird verhindert, indem das Austreiben in einer sauerstoffhaltigen Atmosphäre bei hohen Temperaturen von 900 bis 1200°C vorgenommen wird. Unter diesen Bedingungen bildet sich an Rändern und Vorderseite des Wafers sofort eine Oxidschicht aus, die zur Maskierung dient und damit die unerwünschte Dotierung an diesen Stellen verhindert. Nach dem Eintreiben kann sowohl Oxid- als auch die Diffusionsquellschicht durch einen einfachen Ätzschritt entfernt werden.

Die Erzeugung des Back-Surface-Fields (BSF) erfolgt somit vor der Erzeugung des Halbleiterübergangs, also vor der Eindiffusion von Phosphor auf der Vorderseite der Solarzelle. Die gewählten hohen Temperaturen sorgen für ein tiefes Eintreiben der Bordotierung. Diese ist dann auch gegenüber sämtlichen folgenden Herstellungsschritten der Solarzelle stabil, welche bei deutlich niedrigeren Temperaturen durchgeführt werden.

Ein weiterer Vorteil der Erfindung ergibt sich bei der Herstellung des Übergangs durch Eindiffusion von Phosphor. Diese kann rundum, also auf beiden Seiten und an den Rändern des Wafers erfolgen. Es ist also auch für die Phosphordiffusion weder eine Maskierung noch eine Abdeckung von Schichtbereichen erforderlich, um eine unerwünschte Dotierung in bestimmten Bereichen auszuschließen. Die tief eingetriebene BSF-Dotierung wird nur oberflächlich vom Phosphor überkompensiert.

Mit dem aluminiumhaltigen Material des Rückseitenkontakts wiederum gelingt es, beim Einbrennen des Rückseitenkontakts zur p⁺-Schicht durchzukontaktieren und dabei im Bereich des Rückseitenkontakt die n⁺-Schicht wieder zu kompensieren. Der Rückseitenkontakt kann dabei strukturiert oder ganzflächig aufgebracht werden.

Die Diffusionsquellschicht ist eine borhaltige Schicht, aus der sich das Bor thermisch austreiben läßt. Vorzugsweise wird die Diffusionsquellschicht mit Hilfe eines Bordotierlacks aufgebracht. Dieser enthält neben Bor oder seinen Verbindungen noch pulvriges SiO₂ in einer Aufschlämmung. Dieser Dotierlack dient üblicherweise zum Erzeugen hoher Dotierungen bei Leistungshalbleitern. Er kann flüssig aufgebracht und beispielsweise aufgeschleudert werden.

Vorzugsweise ist die Rückseite der Solarzelle hydrophob und damit oxidfrei eingestellt. Auf diese Oberfläche wird der Dotierlack in möglichst dünner Schicht aufgebracht und getrocknet. Dadurch wird verhindert, daß die Diffusionsquellschicht beim Eintreiben Risse bildet oder gar abplatzt. Mit einer homogenen und unbeschädigten Diffusionsquelleschicht wird eine homogene Dotierung der Rückseite erreicht.

Das Eintreiben des Bors aus der Diffusionsquellschicht in die Solarzelle erfolgt bei 900 bis 1200°C, vorzugsweise bei 1000 bis 1100°C. Dieser Bereich liegt unter den 1280°C, die vom Hersteller des Dotierlacks für die Anwendung vorgeschlagen werden. Dennoch liegt die Eintreibtemperatur höher, als es bei Solarzellen bisher üblich war.

Für die Anwendung von Bordotierlack wurde von dessen Hersteller bisher vorgeschlagen, die Bauelemente bzw. Wafer einseitig mit dem Lack zu beschichten und so in einem Stapel übereinander zu legen, daß dabei jeweils zu dotierende bzw. nicht zu dotierende Oberflächen übereinander zu liegen kommen. So soll eine Dotierung der jeweils gegenüberliegenden Oberfläche verhindert werden, ohne daß eine Maskierung erforderlich ist. Dieses vorgeschlagene Verfahren hat jedoch den Nachteil, daß die Bauelemente bzw. Wafer bei den hohen erforderlichen Eintreibtemperaturen zusammenbacken und anschließend mechanisch oder chemisch voneinander getrennt werden müssen.

Beim erfindungsgemäßen Verfahren ist weder eine Maskierung noch eine Abdeckung der nicht zu dotierenden Bereiche durch Stapeln erforderlich. Beim Eintreiben der Dotierung sind die Solarzellen (Wafer) im Abstand zueinander angeordnet, so daß kein Zusammenbacken erfolgen kann.

Beim Eintreiben der Dotierung muß die Atmosphäre sauerstoffhaltig sein. Vorzugsweise wird unter reiner Sauerstoffatmosphäre gearbeitet. Damit sich die Oxidschicht sofort ausbilden kann, werden die Solarzellen direkt in einen auf die Eintreibtemperatur vorgeheizten Ofen eingebracht. Nach der schnellen Ausbildung des Oxids kann die Sauerstoffatmosphäre durch andere Gase, beispielsweise durch Stickstoff ersetzt werden.

Ein weiterer Vorteil des erfindungsgemäßen Verfahrens ergibt sich aus der hohen Affinität einer Oxidschicht gegenüber Bor, die größer ist als diejenige von Silizium gegenüber Bor. Dies bewirkt, daß gegebenenfalls beim Eintreiben der Dotierung in die Atmosphäre entweichendes flüchtiges Bor von der Oxidschicht absorbiert wird und nur geringfügig in die von der Bordotierung auszuschließenden Oberflächenbereiche eindringen kann.

Nach dem Abkühlen werden sowohl Diffusionsquellschicht als auch Oxidschicht entfernt, beispielsweise durch einen HF-Dip.

Der für die Solarzelle erforderliche Halbleiterübergang wird durch Eindiffusion von Phosphor erzeugt. Dies kann durch Rundumdiffusion erfolgen, wobei neben der n⁺-dotierten Emitterschicht auf der Vorderseite auch auf der Rückseite ein flacher n⁺-dotierter Schichtbereich entsteht. Da bei der Eindiffusion des Phosphors bei ca. 800 bis 900°C eine wesentlich niedrigere Temperatur als beim Eintreiben des Bors eingestellt wird, bleibt auf der Rückseite der Solarzelle die mit eins bis fünf µm wesentlich tiefere p⁺-Dotierung unter der ca. 0,2 µm tiefen n+-Dotierung erhalten.

Um ein funktionsfähiges Halbleiterbauelement zu erhalten, muß die n+-Dotierung am Rand der Solarzelle aufgetrennt werden.

Damit werden Kurzschlüsse und daraus resultierende Leistungsverluste der Solarzelle vermieden. Zum Auftrennen können die Solarzellen übereinander gestapelt werden und für kurze Zeit einem Ätzplasma ausgesetzt werden.

Um einen funktionsfähigen Rückseitenkontakt zu erhalten, muß auf der Rückseite die p⁺-Schicht durch die n⁺-Schicht hindurch kontaktiert werden. Dies wird mit einem Rückseitenkontakt erreicht, der ca. 1 bis 3 Gewichtsprozent Aluminium enthält. Das Aluminium dringt beim Einbrennen des Rückkontakts in die Rückseite der Solarzelle ein und erzeugt dort eine p⁺-Dotierung, die unterhalb des Rückkontakts die n⁺-Dotierung überkompensiert. Somit ist ein niederohmiger Anschlußbereich unterhalb des Rückkontakts erzeugt, der für eine gute Stromableitung während des Betriebs der Solarzelle sorgt.

Der für eine funktionsfähige Solarzelle noch fehlende stromableitende Kontakt an der Vorderseite (Vorderseitenkontakt) kann in bekannter Weise vor, während oder gleichzeitig mit dem Rückseitenkontakt oder nach dem Einbrennen des Rückseitenkontakts hergestellt werden.

Im folgenden wird die Erfindung anhand eines Ausführungsbeispiels und der dazugehörigen sieben Figuren näher erläutert. Dabei zeigen
- die Figuren 1 bis 4: verschiedene Verfahrensstufen anhand von schematischen Querschnitten durch eine Solarzelle.
- Figuren 5 und 6: zeigen erfindungsgemäß erzeugte Dotierprofile einer Solarzelle und
- Figur 7: zeigt eine fertige Solarzelle im schematischen Querschnitt.

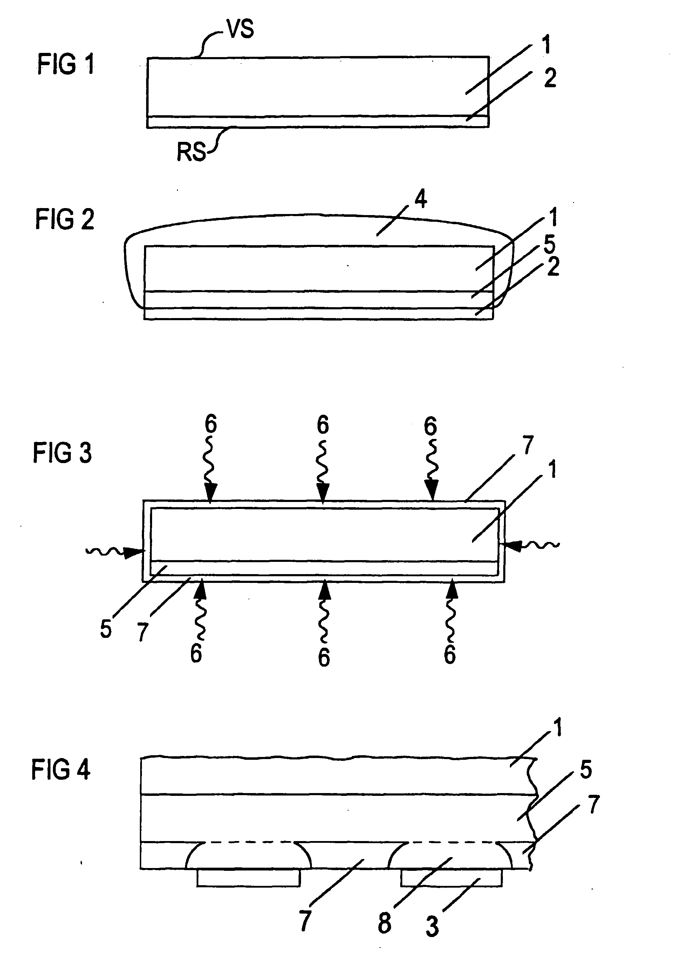

Figur 1: Für die Solarzelle wird beispielsweise ein Wafer aus p-dotiertem Cz-Silizium mit <100>-Orientierung gewählt. Bei diesem kann durch eine kurze, basische kristallorientierte Ätzung eine Texturierung auf der Oberfläche erzeugt werden, die die Lichteinfallsgeometrie zur Verhinderung von Reflexion verbessert (in der Figur 1 nicht dargestellt).

Auf der Rückseite RS wird nun eine dünne Dotierlackschicht 2 (zum Beispiel Siodop ^{®}, Firma Merck) aufgeschleudert und getrocknet.

Figur 2: Der so vorbereitete Wafer wird nun in eine Horde eingestellt und in einen auf 1000 bis 1100°C vorgeheizten Ofen eingebracht. Im Ofen ist eine reine Sauerstoffatmosphäre eingestellt, so daß sich unmittelbar auf allen nicht von der Bordotierlackschicht 2 bedeckten Oberflächen des Wafers 1 eine Oxidschicht 4 ausbildet. Gleichzeitig wird Bor aus der Dotierlackschicht 2 ausgetrieben und diffundiert in die Rückseite RS des Wafers 1 ein. Dabei bildet sich ein ca. 1 bis 5 µm tiefes p⁺-dotiertes Gebiet 5 aus.

Mit einem HF-Dip werden Oxidschicht 4 und Dotierlackschicht 2 vom Wafer entfernt.

Figur 3: Durch Eindiffusion von Phosphor (siehe Pfeile 6) wird nun rundum ein flacher n+-dotierter Oberflächenbereich 7 erzeugt. Die Bedingungen werden so eingestellt, daß der n⁺-dotierte Bereich 7 eine Tiefe von ca. 1 µm, vorzugsweise von 0,2 µm erreicht.

Figur 4: Nach dem Auftrennen des n⁺-Bereichs 7 am Rand der Scheibe durch Abätzen, (beispielsweise in einem Plasma) wird ein Rückkontakt 3 aufgebracht. Dies erfolgt beispielsweise durch Siebdruck mit einer Paste, die neben Bindemitteln und oxidischen Zuschlägen leitfähige Silberpartikel sowie 1 bis 3 Gewichtsprozent Aluminium enthält. Nach dem Aufdrucken wird der Rückkontakt 3 bei ca. 700 bis 800°C eingebrannt. Dabei wird der zusätzlich in der Paste enthaltene Dotierstoff Aluminium in die Solarzellenrückseite eingetrieben und sorgt dort im Anschlußbereich 8 durch Überkompensation der n⁺-Dotierung für eine p⁺-Dotierung und damit für einen guten ohmschen Kontakt zwischen dem p⁺-Gebiet 5 und dem Rückkontakt 3.

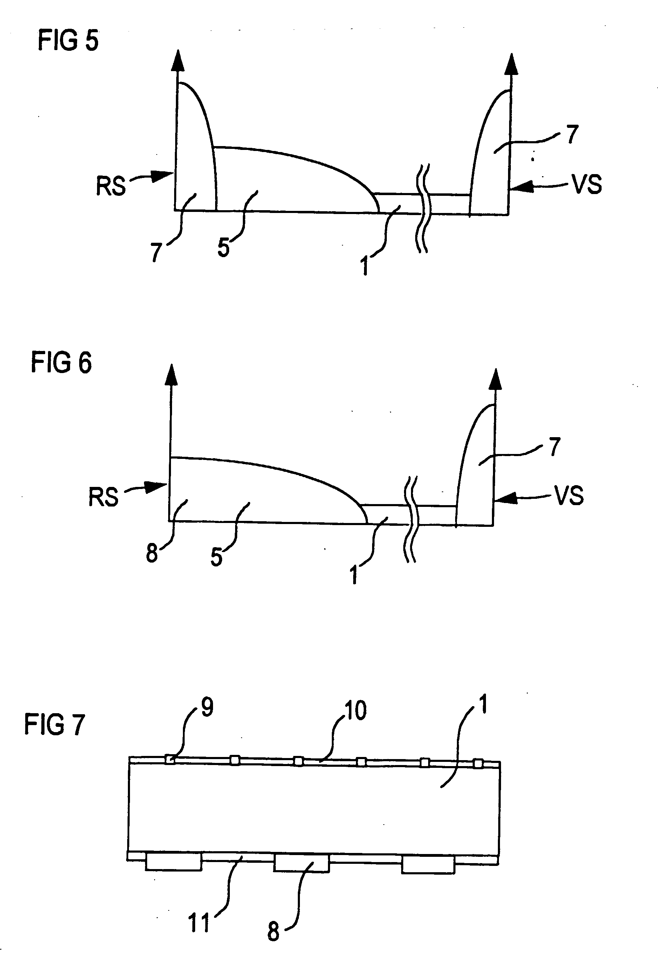

Figur 5 zeigt das erzeugte Dotierprofil in der Solarzelle vor dem Einbrennen des Rückkontakts in schematischer Darstellung. Dabei ist die Dotierkonzentration gegen die Scheibendicke zwischen Rückseite RS und Vorderseite VS aufgetragen. Der Bereich 1 stellt die niedrige gleichmäßige ursprüngliche pDotierung des Wafers dar. Der Bereich 5 kennzeichnet die p⁺-Dotierung, die ca. 5 µm in die Rückseite RS des Wafers eingetrieben ist. Die durch die Phosphordiffusion erzeugte n⁺-Dotierung 7 mit geringer Eindringtiefe von ca. 0,2 µm bildet an der Vorderseite den Emitter aus und erzeugt an der Rückseite durch Überkompensierung der p⁺-Dotierung ebenfalls einen n⁺-dotierten Bereich.

In Figur 6 ist das Dotierprofil nach dem Einbrennen des Rückkontakts dargestellt, wobei der Rückkontakt im Schnittbereich der dargestellten Querschnittsebene liegt. Durch das Aluminium wird im Anschlußbereich die n⁺-Dotierung der Rückseite überkompensiert, so daß ein durchgehend p⁺-dotierter Bereich 8 unterhalb des Rückkontakts entsteht. Ein guter ohmscher Kontakt des aufgedruckten und eingebrannten Rückkontakts zur Solarzelle ist somit gewährleistet.

Figur 7 zeigt eine mittels an sich bekannter Verfahrensschritte fertiggestellte Solarzelle im schematischen Querschnitt. Diese weist zumindest einen Vorderseitenkontakt 9 auf, sowie wahlweise eine Antireflexschicht 10 auf der Vorderseite, die beispielsweise aus einem Oxid oder aus Siliziumnitrid ausgebildet sein kann, sowie eine Rückseitenpassivierungsschicht 11, beispielsweise ein Passivierungsoxid. Diese beiden Schichten können wahlweise vor dem Aufbringen von Vorder- und/oder Rückkontakt erzeugt werden. Aufgrund der hohen Oberflächendotierung wächst dabei ein Oxid besonders schnell, so daß zur Passivierung bereits mäßige Temperaturen und kurze Prozeßzeiten ausreichend sind.

## Patentansprüche

1. Verfahren zum Erzeugen einer Siliziumsolarzelle mit Back-Surface-Field, umfassend die Schritte:
a) Aufbringen einer Bor als Dotierstoff enthaltenden Diffusionsquellschicht (2) auf der Rückseite (RS) eines p-dotierten Wafers (1) aus Silizium,
b) Behandeln des Wafers (1) in einer Sauerstoff enthaltenden Atmosphäre bei einer Temperatur von 900 bis 1200°C zum Erzeugen einer Oxidschicht (4) an den Rändern und auf der Vorderseite, und zum Eintreiben des Dotierstoffs,
c) Entfernen der Diffusionsquellschicht (2) und der Oxidschicht (4),
d) Rundumdiffusion von Phosphor zum Erzeugen einer n⁺ dotierten Emitterschicht (7),
e) Auftrennen der n⁺ dotierten Schicht (7) am Rand des Wafers,
f) Aufbringen eines Aluminium enthaltenen Rückkontakts (3),
g) Einbrennen des Rückkontakts (3),
h) Herstellen eines Vorderseitenkontakts (9).

2. Verfahren nach Anspruch 1, bei dem im Schritt a) als Diffusionsquellschicht (2) eine Bordotierlack-Schicht aufgebracht wird.

3. Verfahren nach Anspruch 1 oder 2,
bei dem der Wafer (1) im Schritt b) einer Temperatur von 1000 bis 1100°C ausgesetzt wird.

4. Verfahren nach einem der Ansprüche 1 bis 3,
bei dem im Schritt c) Diffusionsquellschicht (2) und Oxidschicht (4) durch Ätzen mit HF-Lösung entfernt werden.

5. Verfahren nach einem der Ansprüche 1 bis 4, bei dem im Schritt e) mehrere Wafer (1) dicht über- oder nebeneinander gestapelt werden und bei dem das Auftrennen der n⁺ dotierten Schicht (7) durch Abätzen der Aussenränder der Wafer erfolgt.

6. Verfahren nach einem der Ansprüche 1 bis 5,
bei dem der Rückkontakt durch Aufdrucken einer aluminiumhaltigen Silbersiebdruckpaste aufgebracht wird.

7. Verfahren nach einem der Ansprüche 1 bis 6,
bei dem in Schritt f) ein Rückkontakt (3) aufgebracht wird, der 1 bis 3 Gewichtsprozent Aluminium enthält.

8. Verfahren nach einem der Ansprüche 1 bis 7,
bei dem das Bor im Schritt b) bis in eine Tiefe von 1 bis 5 µm eingetrieben wird.

9. Siliziumsolarzelle
- mit einem p⁻ dotierten Solarzellenkörper (1),
- mit einem 1 bis 5 µm tiefen mit Bor p⁺ dotierten Schichtbereich (5) auf der Rückseite (RS),
- mit einem n⁺ dotierten Schichtbereich (7) zumindest auf der Vorderseite,
- mit einem Vorderseitenkontakt (9),
- mit einem eingebrannten aluminiumhaltigen Silber-Rückkontakt (3), und
- mit einem Aluminium dotierten Anschlußbereich (8) im Bereich des Rückkontakts (3).

10. Solarzelle nach Anspruch 9,
bei der der Rückkontakt (3) nicht ganzflächig aufgebracht ist und bei dem zwischen den vom Rückkontakt bedeckten Bereichen der Rückseite die Bordotierung (5) von einer flacheren n⁺-Dotierung (7) überkompensiert ist.

11. Solarzelle nach Anspruch 9 oder 10,
umfassend eine Antireflexschicht (10) auf der Vorderseite (VS) und eine Oxidschicht (11) als Passivierungsschicht auf der Rückseite (RS).

## Claims

1. A method of generating a silicon solar cell with a back-surface field comprising the steps of
a) applying a diffusion source layer (2) that contains boron as a dopant on the back side (RS) of a p⁻ doped silicon wafer (1),
b) treating said wafer (1) in an atmosphere that contains oxygen at a temperature of 900 to 1200°C to generate an oxide layer (4) at the edges and on the front side and to drive in said dopant,
c) removing said diffusion source layer (2) and said oxide layer (4),
d) diffusing phosphorus on all sides of the wafer to generate an n⁺ doped emitter layer (7),
e) separating said n⁺ doped layer (7) at the edge of said wafer,
f) applying a back contact (3) that contains aluminium,
g) burning in said back contact (3),
h) producing a front side contact (9).

2. A method according to claim 1,
wherein a boron doping resist layer is applied in step a) as a diffusion source layer (2).

3. A method according to claim 1 or 2,
wherein said wafer (1) is exposed to a temperature of 1000 to 1100°C in step b).

4. A method according to one of claims 1 to 3,
wherein the diffusion source layer (2) and the oxide layer (4) are removed by etching using HF solution in step c).

5. A method according to one of claims 1 to 4,
wherein a plurality of wafers are provided and said wafers (1) are densely stacked above or next to one another in step e) and wherein the separation of said n⁺ doped layer takes place by etching off the outer edges of said wafers.

6. A method according to one of claims 1 to 5,
wherein the back contact is applied by imprinting a silver screen printing paste that contains aluminium.

7. A method according to one of claims 1 to 6,
wherein a back contact (3) which contains 1 to 3 per cent by weight aluminium is applied in step f).

8. A method according to one of claims 1 to 7,
wherein the boron is driven to a depth of 1 to 5 µm in step b).

9. A silicon solar cell comprising:
- a p⁻ doped solar cell body (1),
- a layer region (5) being p⁺ doped with boron and having a depth of 1 to 5 µm on said back (RS),
- an n⁺ doped layer region (7) at least on the front side,
- a front side contact (9),
- a burned-in silver back contact (3) that contains aluminium, and
- an aluminium-doped connection region (8) in the region of said back contact (3).

10. A solar cell according to claim 9,
wherein said back contact (3) is not applied along its complete face and said boron doping (5) is overcompensated by a flatter n⁺ doping (7) between those regions of the back covered by said back contact.

11. A solar cell according to claim 9 or 10,
comprising an antireflective layer (10) on the front side (VS) and an oxide layer (11) as a passivating layer on the back (RS).

## Revendications

1. Procédé de production d'une cellule solaire au silicium avec un champ électrique arrière, comprenant les étapes :
a) application d'une couche source de diffusion (2) comprenant du bore comme impureté de dopage sur le côté arrière (RS) d'une galette de silicium à dopage p (1),
b) traitement de la galette (1) dans une atmosphère contenant de l'oxygène à une température de 900 à 1200° C pour produire une couche d'oxyde (4) aux bords et sur le côté avant, et pour introduire l'impureté de dopage,
c) enlèvement de la couche source de diffusion (2) et de la couche d'oxyde (4),
d) diffusion de phosphore sur tous les côtés de la galette pour produire une couche émettrice à dopage n+ (7),
e) séparation de la couche à dopage n+ (7) au bord de la galette,
f) application d'un contact arrière (3) comprenant de l'aluminium,
g) gravure du contact arrière (3).

2. Procédé selon la revendication 1, dans lequel une couche de peinture de dopage au bore est appliquée comme couche source de diffusion (2) à l'étape a).

3. Procédé selon la revendication 1 ou 2, dans lequel la galette (1) est exposée à une température de 1000 à 1100° C à l'étape b).

4. Procédé selon l'une des revendications 1 à 3, dans lequel la couche source de diffusion (2) et la couche d'oxyde (4) sont enlevées par décapage avec une solution HF à l'étape c).

5. Procédé selon l'une des revendications 1 à 4, dans lequel plusieurs galettes (1) sont empilées étroitement les unes au-dessus ou à côté des autres à l'étape e) et dans lequel la séparation de la couche à dopage n+ (7) a lieu par décapage des bords extérieurs des galettes.

6. Procédé selon l'une des revendications 1 à 5, dans lequel le contact arrière est appliqué par impression d'une pâte pour sérigraphie à l'argent contenant de l'aluminium.

7. Procédé selon l'une des revendications 1 à 6, dans lequel un contact arrière (3) qui contient de 1 à 3 pourcent en poids d'aluminium est appliqué à l'étape f).

8. Procédé selon l'une des revendications 1 à 7, dans lequel le bore est introduit jusqu'à une profondeur de 1 à 5µm à l'étape b).

9. Cellule solaire au silicium comprenant :
- un corps de cellule solaire à dopage p- (1)
- une région de couche (5) à dopage p+ au bore et d'une profondeur de 1 à 5 µm sur le côté arrière (RS),
- une région de couche à dopage n+ (7) au moins sur le côté avant,
- un contact (9) sur le côté avant,
- un contact arrière en argent (3) contenant de l'aluminium gravé, et
- une région de connexion (8) dopée à l'aluminium dans la région du contact arrière (3).

10. Cellule solaire selon la revendication 9 dans laquelle le contact arrière (3) n'est pas appliqué de toute sa surface et dans laquelle le dopage au bore (5) est surcompensé par un dopage n+ plus plat (7) entre les régions du côté arrière couvertes par le contact arrière.

11. Cellule solaire selon la revendication 9 ou 10, comprenant une couche antireflet (10) sur le côté avant (VS) et une couche d'oxyde (11) comme couche de passivation sur le côté arrière (RS).
